# EUROPÄISCHE PATENTANMELDUNG

(11) **EP 0 688 156 A2**
(43) Veröffentlichungstag der Anmeldung: **20.12.1995**
(21) Anmeldenummer: 95107910.2
(22) Anmeldetag: 23.05.1995
(51) Int. Cl.: H05K 7/14

(54) **Träger zur Aufnahme von steckbaren Elektronikbaugruppen**

(30) Priorität: 13.06.1994 DE 4420526
(71) Anmelder: Siemens Nixdorf Informationssysteme AG, D-33106 Paderborn (DE)
(72) Erfinder: Kannler, Bernhard, D-86199 Augsburg (DE); Patscheck, Max, D-24944 Flensburg (DE)
(74) Vertreter: Fuchs, Franz-Josef, Dr.-Ing.

(57) **Zusammenfassung**

Die Erfindung bezieht sich auf einen Träger zur Aufnahme von steckbaren Elektronikbaugruppen. Beim Einschieben und Stecken von Elektronikbaugruppen mit vielpoligen Steckern, treten hohe Steckkräfte auf, die nur ein ungleichmäßiges ruckartiges Einstecken der Elektronikbaugruppe ermöglichen. Zur Vermeidung dieses Nachteils sieht die Erfindung vor, daß die Führungsschienen, in denen die Elektronikbaugruppe geführt wird, an einer Trägerseite paarweise freitragend angeordnet sind, und jeweils an ihren freien Enden kurvenförmige Konturen (2) aufweisen, entlang denen eine hakenförmige Ausbildung (13) eines Griffes (3), der an den den Steckerseiten gegenüberliegenden Seiten der Elektronikbaugruppe (4) befestigt ist, beim Einstecken oder Ziehen der Elektronikbaugruppe (4) entlanggleitet, wodurch diese Kontur zugleich als Steckhilfe wirkt, in der die Drehbewegung des Griffes in eine gradlinige Einschubbewegung umgewandelt wird.

## Beschreibung

Die Erfindung betrifft einen Träger zur Aufnahme von steckbaren Elektronikbaugruppen gemäß den Merkmalen im Oberbegriff des Anspruchs 1.

Träger zur Aufnahme von steckbaren Elektronikbaugruppen sind z.B. aus dem Artikel "Die Einbautechnik D und ihr konstruktiver Aufbau" von W. Völkl in der Zeitschrift "Feinwerktechnik & Messtechnik 85 (1977) 1", Seiten 25 bis 29, bekannt. Derartige Träger bestehen aus einem Gehäuse, das rückseitig mit einer Verdrahtungsplatte abgeschlossen ist, in die über an ihr befestigte Führungsschienen Elektronikbaugruppen eingeschoben, und die an der Vorderseite dieser Baugruppen befindlichen Stecker in Fassungen, die sich an der Rückwandverdrahtungsplatte befinden, eingesteckt werden. Diese Stecktechnik ist problemlos, wenn die Zahl der Steckkontakte klein ist. Durch die zunehmende Miniaturisierung der Bauteile, insbesondere der integrierten Schaltkreise, kann jedoch eine immer größere Zahl von Bauteilen auf einer Leiterplatte untergebracht werden, wodurch sich auch die Zahl der notwendigen Steckkontaktstifte erhöht. Dadurch treten beim Einstecken und Herausziehen der Elektronikbaugruppen aus der Rückwandverdrahtung erhebliche Kräfte auf, und der Steckvorgang läßt sich nur noch ruckartig bewältigen.

Aufgabe der vorliegenden Erfindung ist es, bei derartigen Trägern für steckbare Elektronikbaugruppen, insbesondere das Einschieben der Elektronikbaugruppen aus der Rückwandverdrahtungsplatte zu erleichtern.

Gelöst wird diese Aufgabe gemäß den Merkmalen im kennzeichnenden Teil des Anspruchs 1.

Durch diese Maßnahmen lassen sich die Steckkräfte beim Einschieben von Elektronikbaugruppen leichter überwinden und der ruckartige Aufprall beim Überwinden der Steckkräfte auf die Rückwandverdrahtung wird vermieden und eine gleichmäßige Längsbewegung erreicht.

Eine besonders günstige Ausgestaltung wird dadurch erreicht, daß die kurvenförmige Kontur kuppenförmig ausgebildet ist, wobei die Tangente am Scheitelpunkt der Kuppe etwa eine Steigung von 45° hat.

Durch das Einrasten einer nach oben gewölbten Blattfeder in die Führungsnut der Führungsschiene, wird die Elektronikbaugruppe in der gewünschten Position festgehalten.

Anhand der Ausführungsbeispiele nach den Figuren 1 bis 3, wird die Erfindung näher erläutert. Es zeigen
- Figur 1: eine perspektivische Darstellung einer in einen Träger eingeschobenen Elektronikbaugruppe,
- Figur 2: den Einschiebe- und Ziehvorgang für die Elektronikbaugruppe in vier verschiedenen Positionen,
- Figur 3: eine perspektivische Darstellung einer Führungsschiene, von der der kurvenförmigen Kontur abgewandten Seite.

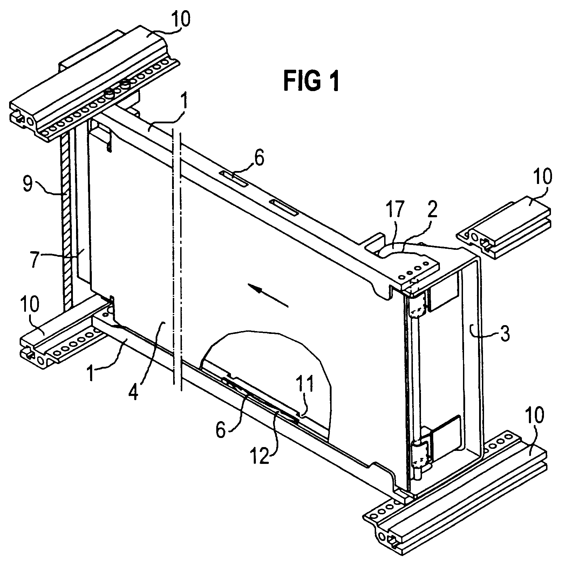

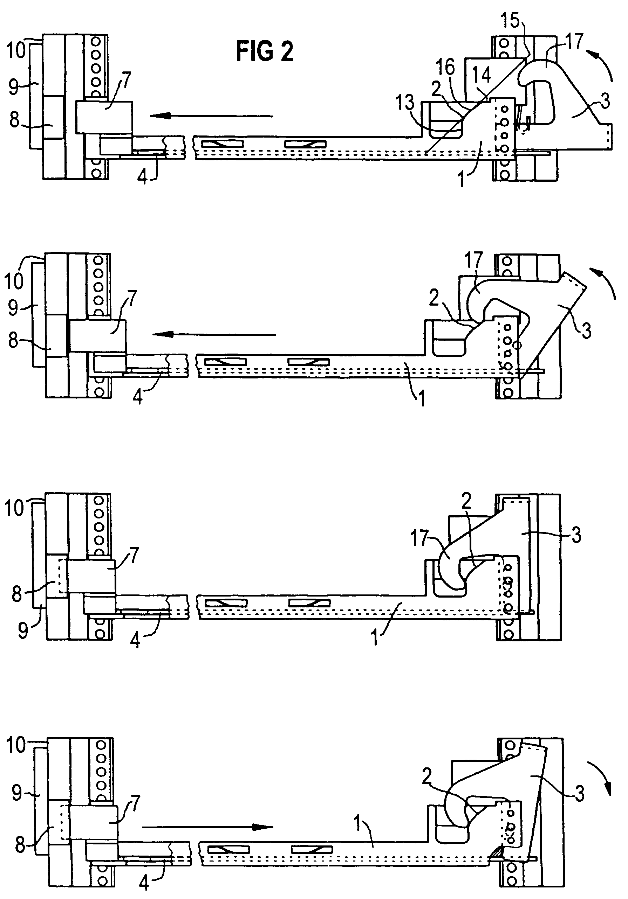

Der Träger besteht aus einem kubischen Gestell mit Strangpreßprofilen, das durch Anbringung von Seitenwänden auch zu einem Baugruppen- oder Schrankgehäuse ausgebildet sein kann. Die Rückwand derartiger Träger wird meistens durch die Rückwandverdrahtungsplatte 9, wie in Figur 1 dargestellt, gebildet, auf der sich Fassungen 8, wie in Figur 2 gezeigt, befinden. In diese Fassungen 8 greifen die auf der Elektronikbaugruppe 4 befindlichen Stecker 7 ein. Die Elektronikbaugruppe 4 wird von Führungsschienen 1, die paarweise an den Strangpreßprofilschienen 10 befestigt sind, geführt. Diese Profilschienen 10 sind in Figur 1 als Teil der Rahmenkonstruktion gezeigt. Die Führungsschienen 1 sind freitragend eingebaut. Der Einbau in ein geschlossenes Gehäuse, z.B. aus Blech, ist ebenfalls möglich. Die Führungsschienen können in Zink- oder Alu-Druckguß, oder als Kunststoff-Spritzgußteile ausgeführt werden. Die Elektronikbaugruppe 4 enthält auf der der Steckerseite gegenüberliegenden Seite einen um die Eleltronikbaugruppe 4 schwenkbaren U-förmigen Bügelgriff 3, der an der Ober- und Unterseite rechtwinkelig abgebogen, hakenförmige Ausbildungen 17 aufweist. Die Führungsschienen haben auf diesem Ende kurvenförmige Konturen 2, über die die hakenförmigen Ausbildungen des U-förmigen Bügelgriffes 3 beim Schwenken des U-förmigen Bügelgriffes gleiten und dadurch insbesondere den Einschiebvorgang kontinuierlich und kräftesparend ermöglichen. Diese kurvenförmigen Konturen sind kuppenförmig ausgebildet, wobei die Tangente 15 im Scheitelpunkt 16 der Kuppe etwa in einem Winkel von ca. 45° gegenüber der Waagrechten der Führungsschiene 1 verläuft, und die eine Hangseite 13 der Kuppe in eine senkrechte und die andere Hangseite der Kuppe 14 in eine waagrechte Linie ausläuft.

In Figur 2 sind vier Einschubpositionen dargestellt, wobei in der obersten Darstellung der Anfangszustand, bei der der Stecker 7 auf der Elektronikbaugruppe 4 noch nicht mit der Fassung 8 auf der Rückwandverdrahtungsplatte 9 in Eingriff steht, und der Griff 3 noch nicht geschwenkt ist.

In der zweiten Position ist der Griff bereits etwa um 45° geschwenkt, und die hakenförmige Ausbildung 17 sitzt am Anfang der kurvenförmigen Kontur 2 auf.

Die Position 3 zeigt den Endzustand, bei dem der Stecker 7 in die Fassung 8 der Rückwandverdrahtung 9 vollständig eingeschoben ist, und die hakenförmige Ausbildung 17 an der Hangseite 13 der Kuppe der kurvenförmigen Kontur 2 angelangt ist. Dabei ist der vollständige Einschub in der Weise vonstatten gegangen, daß die hakenförmige Ausbildung 17 des schwenkbaren U-förmigen Bügelgriffes 3 die Kuppe der kurvenförmigen Kontur 2 der Führungsschiene 1 während des Gleitens über die Kuppe mit einem vorgegebenen Kraftverlauf von sich weggedrückt hat, so daß für die Elektronikbaugruppe 4 samt schwenkbarem U-förmigen Bügelgriff 3 eine mit dem oben angesprochenen vorgegebenen Kraftverlauf beaufschlagte Linearbewegung in Richtung Rückwandverdrahtungsplatte 9 entstanden ist.

Die Position 4 zeigt den Beginn des Herausziehvorgangs, bei der sich der Griff 3 an der Führungsschiene 1 abstützt und so als Ziehhilfe wirkt.

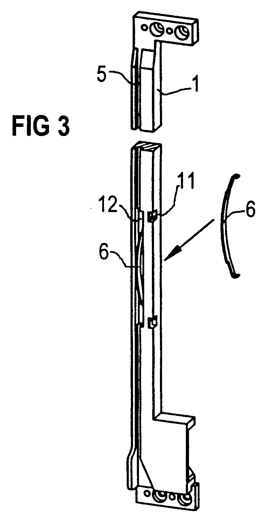

Die Führungsschiene 3 weist, wie in Figur 3 gezeigt, eine Führungsnut 5 auf, in der eine konkav gebogene Feder 6 in den Öffnungen 11 eingerastet ist, so daß sie gegen den oberen und unteren Rand der eingeschobenen Elektronikbaugruppe drückt, wodurch diese in der jeweils gewünschten Position festgehalten wird. Die Ausnehmung 12 dient dabei zur Aufnahme der Feder und ihrer Lagefixierung.

## Patentansprüche

1. Träger zur Aufnahme von steckbaren Elektronikbaugruppen, die in an einer Trägerseite befestigten Führungsschienen geführt sind, und die an ihrem einen Ende jeweils einen Stecker aufweisen, der in eine jeweils zugehörige Fassung einer Rückwandverdrahtungsplatte eingreift, **dadurch gekennzeichnet,** daß die Führungsschienen (1) an einer Trägerseite paarweise freitragend angeordnet sind, und jeweils an ihren freien Enden in Bezug auf einen senkrechten Einbau der Elektronikbaugruppe (4) waagrecht liegende, kurvenförmige Konturen (2) mit einer mit einer ersten Hangseite (13) in einer senkrechten Linie und mit einer zweiten Hangseite (14) in einer waagrechten Linie zur Führungsschiene (1) auslaufenden Kuppe aufweisen, entlang denen eine hakenförmige Ausbildung (17) eines U-förmigen Bügelgriffes (3), der an dem der Steckerseite gegenüberliegenden Seite der Elektronikbaugruppe (4) um die Elektronikbaugruppe (4) schwenkbar befestigt ist, beim Einstecken der Elektronikbaugruppe (4) und Schwenken des U-förmigen Bügelgriffes (3) in der Weise entlanggleitet, daß die hakenförmige Ausbildung (17) am durch die zweite Hangseite (14) gebildeten Anfang der kurvenförmigen Konturen (2) zunächst aufsitzt, dann unter Wegdrücken der Kuppe über die Kuppe gleitet und schließlich an der ersten Hangseite (13) der kurvenförmigen Kontur (2) anlangt.

2. Träger zur Aufnahme von steckbaren Elektronikbaugruppen nach Anspruch 1, **dadurch gekennzeichnet,** daß die Kuppe der kurvenförmigen Konturen (2) in einem zugehörigen Scheitelpunkt (16) eine Tangente (15) mit einer Steigung im Bereich von 45° aufweist.

3. Träger zur Aufnahme von steckbaren Elektronikbaugruppen nach einem der vorhergehenden Ansprüche, **dadurch gekennzeichnet,** daß in der Führungsschiene (1) jeweils eine nach oben gewölbte Blattfeder (6) eingerastet ist.
